# EUROPEAN PATENT SPECIFICATION

(11) **EP 4 258 548 B1**
(45) Date of publication and mention of the grant of the patent: **25.11.2026**
(21) Application number: 20967539.6
(22) Date of filing: 30.12.2020
(51) Int. Cl.: H03G 3/20, H03F 3/45, H03G 1/00, H03G 3/00, H03G 3/30

(54) **OPERATIONAL AMPLIFIER, DRIVE CIRCUIT, INTERFACE CHIP, AND ELECTRONIC DEVICE**
OPERATIONSVERSTÄRKER, TREIBERSCHALTUNG, SCHNITTSTELLENCHIP UND ELEKTRONISCHE VORRICHTUNG
AMPLIFICATEUR OPÉRATIONNEL, CIRCUIT D'ATTAQUE, PUCE D'INTERFACE ET DISPOSITIF ÉLECTRONIQUE

(43) Date of publication of application: 11.10.2023
(73) Proprietor: Huawei Technologies Co., Ltd., Shenzhen, Guangdong 518129 (CN)
(72) Inventor: WANG, Jingjing, Shenzhen, Guangdong 518129 (CN); QIAN, Zhaohua, Shenzhen, Guangdong 518129 (CN); ZHANG, Bingzhao, Shenzhen, Guangdong 518129 (CN); WU, Chunbiao, Shenzhen, Guangdong 518129 (CN); PENG, Jie, Shenzhen, Guangdong 518129 (CN); KE, Jiandong, Shenzhen, Guangdong 518129 (CN)
(74) Representative: Pfenning, Meinig & Partner mbB
(86) International application number: PCT/CN2020/141405
(87) International publication number: WO 2022/141198

(56) References cited:
- WO-A1-2007/105282
- CN-A- 1 234 649
- CN-A- 1 773 844
- CN-A- 103 107 791
- CN-A- 103 166 627
- CN-A- 104 617 899
- CN-B- 103 166 627
- CN-U- 201 846 315
- US-A1- 2010 019 842
- US-B1- 6 331 803

## Description

### TECHNICAL FIELD

This application relates to the field of power electronics technologies, and in particular, to an operational amplifier, a drive circuit, an interface chip, a gain adjustment method, and an electronic device.

### BACKGROUND

A low voltage differential signaling (Low Voltage Differential Signaling, LVDS) technology is a low voltage swing differential signaling technology, has advantages of low power consumption, low bit error rate, low noise, easy integration, and the like, and is widely used in various data transmission systems.

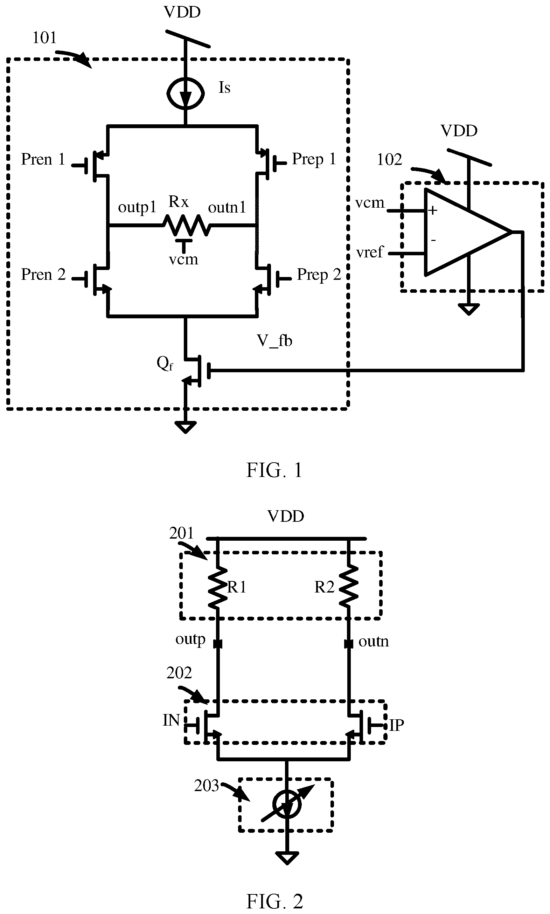

FIG. 1 is a schematic diagram of a low voltage differential signal drive circuit according to the conventional technology.

A low voltage differential signal generation circuit of the low voltage differential signal drive circuit 101 includes a current source Is, two pairs of switching transistors, and a feedback switching transistor Qf. The two pairs of switching transistors are respectively Pren1 and Prep1, and Pren2 and Prep2. A common-mode feedback circuit 102 is implemented by using an operational amplifier, and is configured to adjust a common-mode level Vcm with a change of a reference voltage Vref, to satisfy a multi-scenario and multi-protocol requirement.

FIG. 2 is a schematic diagram of a common-mode feedback circuit according to the conventional technology.

The common-mode feedback circuit is a common-mode feedback operational amplifier, and includes a load 201, an input switching transistor 202, and a tail current source 203. Again (Gain) of the common-mode feedback circuit is a ratio of an output signal to a common-mode input signal. When the gain is adjusted, a magnitude of loads R1 and R2, a width-to-length ratio (Width/Length, W/L) of the input switching transistor, or a magnitude of a tail current output from the tail current source in the operational amplifier needs to be adjusted. The magnitude of the tail current is expressed in I_{bias}, and the gain is directly proportional to (W/L· I_{bias})^{0.5}.

With development of processes, a supply voltage VDD decreases, and a saturation margin of the input switching transistor 202 is greatly compressed. When W/L or I_{bias} is adjusted, a gain adjustment range is non-linear, and a gain adjustment capability is limited. When R1 and R2 are adjusted, a direct-current operating point and an output pole of the operational amplifier are changed. Therefore, in the foregoing manner, it is difficult to ensure normal operating of the common-mode feedback operational amplifier under a process/voltage/temperature (Process/Voltage/Temperature, PVT) condition.

A variable gain amplifier according to WO 2007/105282 A1 comprises a plurality of differential amplifiers connected in parallel and a plurality of signal switching means corresponding to the differential amplifiers, respectively, for switching a positive-phase differential signal and a negative-phase differential signal.

### SUMMARY

The present invention provides an operational amplifier, a drive circuit, an interface chip, a gain adjustment method, and an electronic device according to the independent claims, to linearly adjust a gain without changing a direct-current operating point and an output pole of the operational amplifier, thereby improving stability and adjustment effect. Particular embodiments are defined by the dependent claims.

### BRIEF DESCRIPTION OF DRAWINGS

FIG. 1 is a schematic diagram of a low voltage differential signal drive circuit according to the conventional technology;
FIG. 2 is a schematic diagram of a common-mode feedback circuit according to the conventional technology;
FIG. 3 is a schematic diagram of an operational amplifier according to an embodiment of this application;
FIG. 4 is a schematic diagram of an input adjustment unit according to an embodiment of this application;
FIG. 5 is a schematic diagram of an input switching transistor group of an operational amplifier according to an embodiment of this application;
FIG. 6 is a schematic diagram of an input switching transistor group of another operational amplifier according to an embodiment of this application;
FIG. 7A is a schematic adjustment diagram of a conventional gain adjustment method;
FIG. 7B is a schematic adjustment diagram of an operational amplifier according to an embodiment of this application;
FIG. 8 is a schematic diagram of another operational amplifier according to an embodiment of this application;
FIG. 9 is a schematic diagram of another operational amplifier according to an embodiment of this application;
FIG. 10 is a schematic diagram of a low voltage differential signal drive circuit according to an embodiment of this application;
FIG. 11 is a flowchart of a gain adjustment method for an operational amplifier according to an embodiment of this application;
FIG. 12 is a schematic diagram of an interface chip according to an embodiment of this application;
FIG. 13 is a schematic diagram of another interface chip according to an embodiment of this application;
FIG. 14 is a schematic diagram of still another interface chip according to an embodiment of this application;
FIG. 15 is a schematic diagram of yet another interface chip according to an embodiment of this application; and
FIG. 16 is a schematic diagram of an electronic device according to an embodiment of this application.

### DESCRIPTION OF EMBODIMENTS

To make a person skilled in the art better understand technical solutions provided in embodiments of this application, the following first describes an application scenario of the technical solutions provided in this application.

An operational amplifier and a low voltage differential signal drive circuit that are provided in this application are applied to a data transmission system. A data type is not specifically limited in this application, and may be, for example, audio data or video data. The data transmission system may be a display system, a monitoring system, a vehicle communication system, an industrial control system, or the like.

Refer to FIG. 1. A low voltage differential signal drive circuit includes a main drive circuit 101 and a common-mode feedback circuit 102. The common-mode feedback circuit 102 is a feedback network. The common-mode feedback circuit 102 has a first input end to which a common-mode level Vcm is input and a second input end to which a reference level Vref is input. The common-mode feedback circuit 102 is configured to adjust the common-mode level Vcm with a change of the reference voltage Vref, to satisfy a multi-scenario and multi-protocol requirement.

With development of processes, a transconductance (Transconductance) of a switching transistor becomes larger, a gain of an operational amplifier becomes higher, and a requirement for stability of a closed-loop feedback loop using an operational amplifier also becomes higher. For the drive circuit of a current-mode low voltage differential signal architecture shown in FIG. 1, a gain, a zero, and an output pole of the drive circuit are complex, and the gain, the zero, and the output pole change with a change of an input common mode and an output amplitude. Therefore, an operational amplifier with a fixed gain cannot provide stable common-mode feedback in all cases. Therefore, the gain of the operational amplifier is required to be adjustable. Currently, main indicators for measuring performance of the operational amplifier with an adjustable gain include: a gain adjustment range, a gain adjustment step, influence on a zero and a pole, power consumption, and an area.

Refer to a common-mode feedback circuit shown in FIG. 2. Adc represents a gain of the circuit, W/L represents a size-to-width ratio of an input switching transistor, µ represents a carrier migration rate, Cox represents a gate oxygen capacitance, and I_{bias} represents a tail current, Wp represents a position of an output pole, C_{L} represents a parasitic capacitance of the switching transistor and a load capacitance of an output end, and Vdd represents a supply voltage. Therefore, the foregoing parameters satisfy the following formulas: $Adc = {R}_{L} \sqrt{\frac{W}{L} ⋅ μ ⋅ {C}_{ox} ⋅ {I}_{bias}}$ (1) $Vdc = {V}_{dd} - \frac{{R}_{L}}{2} ⋅ {I}_{bias}$ (2) $Wp = \frac{1}{\left({C}_{L}⋅{R}_{L}\right)}$ (3)

Refer to the foregoing formula (1). When Adc is adjusted in a current gain adjustment solution, one or more of R_{L}, W/L, or I_{bias} may be adjusted. However, with reference to formula (3), when R_{L} is adjusted, the position of the output pole changes. When W/L or I_{bias} is adjusted, a relationship between W/L or I_{bias} and the adjusted item Adc is a square root calculation, that is, an adjustment range is non-linear. The adjustment range of Adc is limited, adjustment efficiency is low, C_{L} is affected, and the output pole of the circuit is changed. Therefore, it is difficult to guarantee normal operating of the operational amplifier.

To resolve the foregoing problem, this application provides an operational amplifier, a drive circuit, an interface chip, an electronic device, and a gain adjustment method. A gain of an operational amplifier is linearly adjusted through a method for adjusting a state of an input switching transistor group, and then controlling proportions of two or more input signals, so that the gain can be linearly adjusted. Moreover, a direct-current operating point and an output pole of the circuit are not changed, and stability and adjustment effect are improved.

To make a person skilled in the art understand the solutions in this application more clearly, the following describes the technical solutions in embodiments of this application with reference to the accompanying drawings in embodiments of this application.

Terms such as "first" and "second" in the following description of this application are merely used for description purposes, and cannot be understood as indicating or implying relative importance or implicitly indicating a quantity of indicated technical features.

In this application, unless otherwise explicitly specified and limited, the term "connection" should be understood in a broad sense. For example, the "connection" may be a fixed connection, a detachable connection, or an integrated connection; and may be a direct connection or an indirect connection through an intermediate medium.

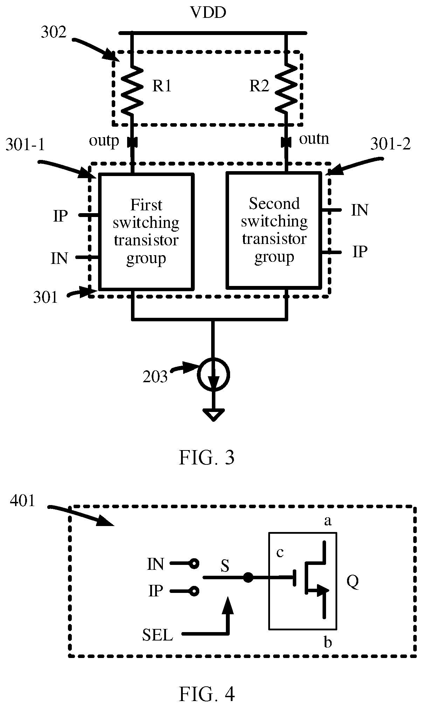

FIG. 3 is a schematic diagram of an operational amplifier according to an embodiment of this application.

As shown in the figure, the operational amplifier includes a first load R1, a second load R2, an input switching transistor group 301, and a tail current source 203.

When the operational amplifier uses a symmetric design structure, parameter values of the first load R1 and the second load R2 are the same. In the following description, parameter values of R1 and R2 are both represented by R_{L}.

The input switching transistor group 301 includes a first switching transistor group 301-1 and a second switching transistor group 301-2.

A first end of the first switching transistor group 301-1 is connected to a first output end (represented by outp in the figure) of the operational amplifier, and is connected to a power supply VDD of the operational amplifier by using the first load R1, and a second end of the first switching transistor group 301-1 is grounded by using the tail current source 203.

A first end of the second switching transistor group 301-2 is connected to a second output end (represented by outn in the figure) of the operational amplifier, and is connected to the power supply VDD by using the second load R1, and a second end of the second switching transistor group 301-2 is grounded by using the tail current source 203.

The first switching transistor group 301-1 and the second switching transistor group 301-2 include a same quantity of at least two input adjustment units, and an input end of each input adjustment unit is connected to only one input signal.

The input signal connected to each input adjustment unit in the first switching transistor group 301-1 and the second switching transistor group 301-2 is adjustable. To be specific, each input adjustment unit may be connected to different input signals.

The following specifically describes a principle of a manner in which the operational amplifier implements gain adjustment.

An example in which the first switching transistor group 301-1 and the second switching transistor group 301-2 each include eight input adjustment units and the operational amplifier supports connection of two input signals is used for description.

IN and IP respectively represent two input signals, A_{dc_tot} represents a total gain of the input switching transistor group 301, A_{dc_p} is an equivalent gain of the input IP, and A_{dc_n} is an equivalent gain of the input IN.

When the first switching transistor group 301-1 has one input adjustment unit connected to IN and seven input adjustment units connected to IP, and the second switching transistor group 301-2 has seven input adjustment units connected to IN and one input adjustment unit connected to IP, the gains are as follows: ${A}_{dc_p} = \frac{7 - 1}{7 + 1} ⋅ {A}_{dc_tot} = 0.75 {A}_{dc_tot}$ (4-1) ${A}_{dc_n} = \frac{7 - 1}{7 + 1} ⋅ {A}_{dc_tot} = 0.75 {A}_{dc_tot}$ (4-2)

After the input signals connected to the switching transistor groups are adjusted to adjust the gains, using an example in which the gains are reduced, when the first switching transistor group 301-1 has two input adjustment units connected to IN and six input adjustment units connected to IP, and the second switching transistor group 301-2 has six input adjustment units connected to IN and two input adjustment units connected to IP, the gains are as follows: ${A}_{dc_p} = \frac{6 - 2}{6 + 2} ⋅ {A}_{dc_tot} = 0.5 {A}_{dc_tot}$ (5-1) ${A}_{dc_n} = \frac{6 - 2}{6 + 2} ⋅ {A}_{dc_tot} = 0.5 {A}_{dc_tot}$ (5-2)

After the input signals connected to the switching transistor groups continue to be adjusted to adjust the gains, when the first switching transistor group 301-1 has three input adjustment units connected to IN and five input adjustment units connected to IP, and the second switching transistor group 301-2 has five input adjustment units connected to IN and three input adjustment units connected to IP, the gains are as follows: ${A}_{dc_p} = \frac{5 - 3}{5 + 3} ⋅ {A}_{dc_tot} = 0.25 {A}_{dc_tot}$ (6-1) ${A}_{dc_n} = \frac{5 - 3}{5 + 3} ⋅ {A}_{dc_tot} = 0.25 {A}_{dc_tot}$ (6-2)

Refer to the foregoing (4-1) to (6-2) together. The range in the foregoing adjustment process is 0.25A_{dc_tot}, linear adjustment can be implemented, and only the type of the input signal connected to the input adjustment unit is changed in the adjustment process. The total quantity of input adjustment units does not change in the adjustment process, and the size, the load, and the tail current of the switching transistor group are not changed.

In this embodiment of this application, input adjustment units of the first switching transistor group 301-1 and the second switching transistor group 301-2 include switching transistors. Types of switching transistors are not specifically limited in this embodiment of this application. In some embodiments, the switching transistor may be an IGBT, a MOSFET, a SiC MOSFET, or the like.

In conclusion, the operational amplifier provided in this application is used to linearly adjust a gain, and a size, a load, and a tail current of the switching transistor group are not changed in the adjustment process. Therefore, a direct-current operating point and an output pole of the operational amplifier are not changed. In addition, because the size of the switching transistor group is not increased in the adjustment process, that is, an area of the switching transistor group and power consumption are not increased, gain adjustment efficiency is further improved.

The following first describes an implementation of the input adjustment unit.

FIG. 4 is a schematic diagram of an input adjustment unit according to an embodiment of this application.

As shown in the figure, the input adjustment unit 401 includes a first selector switch S and a switching transistor Q.

The first selector switch S is connected to a control end c of the switching transistor Q, a first end a of the switching transistor Q is connected to a first end of a switching transistor group in which the switching transistor Q is located, and a second end b of the switching transistor Q is connected to a second end of the switching transistor group in which the switching transistor Q is located.

The first selector switch S is configured to select an input signal to be connected to the control end.

For example, the switching transistor Q is an N-channel metal oxide semiconductor (N-channel metal oxide semiconductor) field effect transistor. For the switching transistor Q, the first end is a drain (Drain), the second end is a source (Source), and the control end is a gate (Gate).

In some embodiments, the first selector switch S selects a to-be-connected input signal based on an adjustment signal SEL. Using an example in which the input signal includes the following two signals: a first input signal and a second input signal, the first input signal is represented by IN, and the second input signal is represented by IP. In this case, the adjustment signal SEL may be a level signal. The first selector switch S selects to connect to the first input signal IN when the adjustment signal SEL is a first level or selects to connect to the second input signal IP when the adjustment signal is a second level. In a possible implementation, the first level is a high level, and the second level is a low level. In another possible implementation, the first level is a low level, and the second level is a high level.

Based on the principle of the input adjustment unit shown in FIG. 4, a person skilled in the art may replace the selector switch S in another possible implementation, to select one of the two inputs based on the adjustment signal and output the selected input to the switching transistor.

The following describes an operating principle of the operational amplifier with reference to a specific implementation.

First, an implementation of adjusting a gain in a symmetric adjustment manner is described.

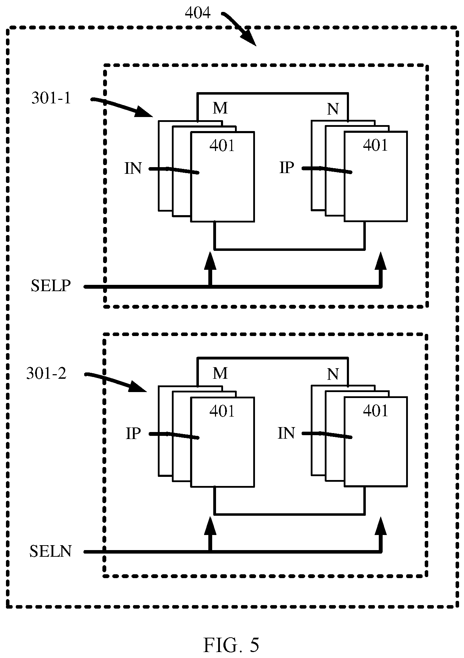

FIG. 5 is a schematic diagram of an input switching transistor group of an operational amplifier according to an embodiment of this application.

As shown in the figure, a first switching transistor group 301-1 and a second switching transistor group 301-2 each include (M+N) input adjustment units 401.

Still using an example in which the input signal includes the following two signals: a first input signal and a second input signal, the first input signal is represented by IN, and the second input signal is represented by IP.

When the symmetric adjustment manner is used, in the first switching transistor group 301-1, a first quantity of input adjustment units is connected to the first input signal, and a second quantity of input adjustment units is connected to the second input signal.

In the second switching transistor group 301-2, the second quantity of input adjustment units is connected to the first input signal, and the first quantity of input adjustment units is connected to the second input signal; and
the first quantity is not equal to the second quantity. As shown in the figure, the first quantity is M, the second quantity is N, and both M and N are integers greater than or equal to 0.

A_{dc_tot} represents a total gain of the input switching transistor group 301, A_{dc_p} is an equivalent gain of the input IP, and A_{dc_n} is an equivalent gain of the input IN, R_{L} represents a load resistance, I_{bias} represents a tail current, W/L represents a ratio of a total width of the input switching transistor group to a channel length, µ represents a carrier migration rate, and Cₒₓ represents a gate oxygen capacitance. Therefore, a gain of the operational amplifier can be linearly adjusted by symmetrically adjusting proportions of the input IP and the input IN in the first switching transistor group 301-1 and the second switching transistor group 301-2, and an adjustment step A_{dc_step} satisfies the following formula: ${A}_{dc_step} = 2 ⋅ {A}_{dc_tot} / \left(M+N\right)$ (7)

The gains of the two inputs are as follows: ${A}_{dc_p} = \frac{N - M}{M + N} ⋅ {A}_{dc_tot}$ (8-1) ${A}_{dc_p} = \frac{N - M}{M + N} ⋅ {A}_{dc_tot}$ (8-2)

A_{dc_tot} satisfies the following formula: ${A}_{dc_tot} = {R}_{L} \sqrt{\frac{W}{L} ⋅ μ ⋅ {C}_{ox} ⋅ {I}_{bias}}$ (9)

In the symmetric adjustment manner, polarity reversal of the operational amplifier may be implemented by adjusting the proportions of the input IP and the input IN. To be specific, when N>M, the input signal IP dominates in 301-1 and the input signal IN dominates in 301-2. In this case, an output gain of the operational amplifier is of a first polarity. Alternatively, when N<M, the input signal IN dominates in 301-1 and the input signal IP dominates in 301-2. In this case, an output gain of the operational amplifier is of a second polarity.

In some embodiments, positiveness and negativeness of the gain respectively correspond to the first polarity and the second polarity. When the gain is positive, that is, when the gain is of the first polarity, it indicates that the operational amplifier is configured to amplify the input signal. When the gain is negative, that is, when the gain is of the second polarity, it indicates that the operational amplifier is configured to scale down the input signal. It should be understood that a polarity of the gain when being negative may alternatively be referred to as the first polarity, and a polarity of the gain when being positive may be referred to as the second polarity.

In the adjustment process, N is required to be not equal to M. Otherwise, the input of the operational amplifier is 0.

In conclusion, the operational amplifier provided in this application is used to linearly adjust a gain in the symmetric adjustment manner, and a size, a load, and a tail current of the switching transistor group are not changed in the adjustment process. Therefore, a direct-current operating point and an output pole of the operational amplifier are not changed. Because a size of the switching transistor group is not increased in the adjustment process, that is, an area of the switching transistor group and power consumption are not increased, gain adjustment efficiency is further improved.

The following describes an implementation in which an operational amplifier uses asymmetric adjustment.

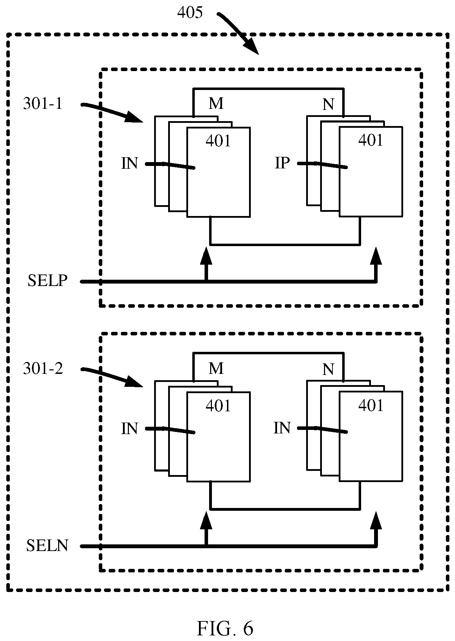

FIG. 6 is a schematic diagram of an input switching transistor group of another operational amplifier according to an embodiment of this application.

As shown in the figure, a first switching transistor group 301-1 and a second switching transistor group 301-2 each include (M+N) input adjustment units 401.

Still using an example in which the input signal includes the following two signals: a first input signal and a second input signal, the first input signal is represented by IN, and the second input signal is represented by IP.

When the asymmetric adjustment manner is used, in the first switching transistor group 301-1, a first quantity of input adjustment units is connected to the first input signal, and a second quantity of input adjustment units is connected to the second input signal.

A third quantity of input adjustment units in the second switching transistor group 301-2 is connected to the first input signal.

As shown in the figure, the first quantity is M, the second quantity is N, M is an integer greater than or equal to 0, N is an integer greater than 0, and the third quantity is equal to a sum of the first quantity and the second quantity.

A_{dc_tot} represents a total gain of the input switching transistor group 301, A_{dc_p} is an equivalent gain of the input IP, and A_{dc_n} is an equivalent gain of the input IN, R_{L} represents a load resistance, I_{bias} represents a tail current, W/L represents a ratio of a total width of the input switching transistor group to a channel length, µ represents a carrier migration rate, and Cₒₓ represents a gate oxygen capacitance. Therefore, a gain of the operational amplifier is linearly adjusted by symmetrically adjusting proportions of the input IP and the input IN in the first switching transistor group 301-1 and the second switching transistor group 301-2, and an adjustment step A_{dc_step} satisfies the following formula: ${A}_{dc_step} = {A}_{dc_tot} / \left(M+N\right)$ (10)

By comparing formula (10) with formula (7), it can be found that in the asymmetric adjustment manner, the adjustment step is smaller and the adjustment precision is higher when the quantity of input adjustment units is the same than those in the symmetric adjustment manner.

The gains of the two inputs are as follows: ${A}_{dc_p} = \frac{N}{M + N} ⋅ {A}_{dc_tot}$ (11-1) ${A}_{dc_n} = \frac{N}{M + N} ⋅ {A}_{dc_tot}$ (11-2)

A_{dc_tot} satisfies formula (9), and N is required to be a positive integer in the foregoing adjustment process.

For asymmetric adjustment, when polarity reversal is not performed, the first selector switch selects to connect to the first input signal when the adjustment signal is a first level or selects to connect to the second input signal when the adjustment signal is a second level.

When polarity reversal is performed, the first selector switch of the first switching transistor group 301-1 selects to connect to the first input signal when the adjustment signal is a first level or selects to connect to the second input signal when the adjustment signal is a second level; and the first selector switch of the second switching transistor group 301-1 selects to connect to the first input signal when the adjustment signal is a second level or selects to connect to the second input signal when the adjustment signal is a first level. In this case, gains of the two inputs are as follows: ${A}_{dc_p} = \frac{M}{M + N} ⋅ {A}_{dc_tot}$ (12-1) ${A}_{dc_n} = \frac{M}{M + N} ⋅ {A}_{dc_tot}$ (12-2)

In conclusion, the operational amplifier provided in this application is used to linearly adjust a gain in the asymmetric adjustment manner, and a size, a load, and a tail current of the switching transistor group are not changed in the adjustment process. Therefore, a direct-current operating point and an output pole of the operational amplifier are not changed. Because a size of the switching transistor group is not increased in the adjustment process, that is, an area of the switching transistor group and power consumption are not increased, gain adjustment efficiency is further improved.

The following describes technical effects of the solutions of this application in detail with reference to accompanying drawings.

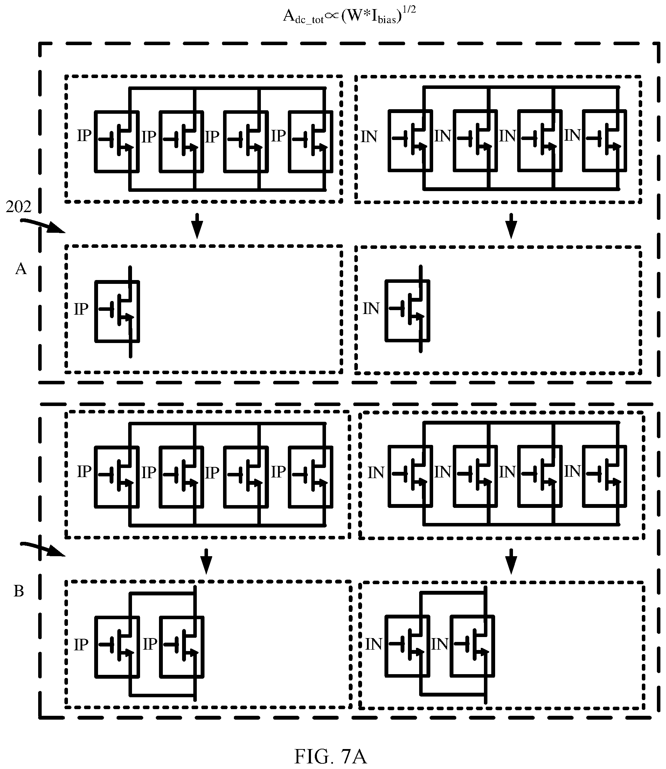

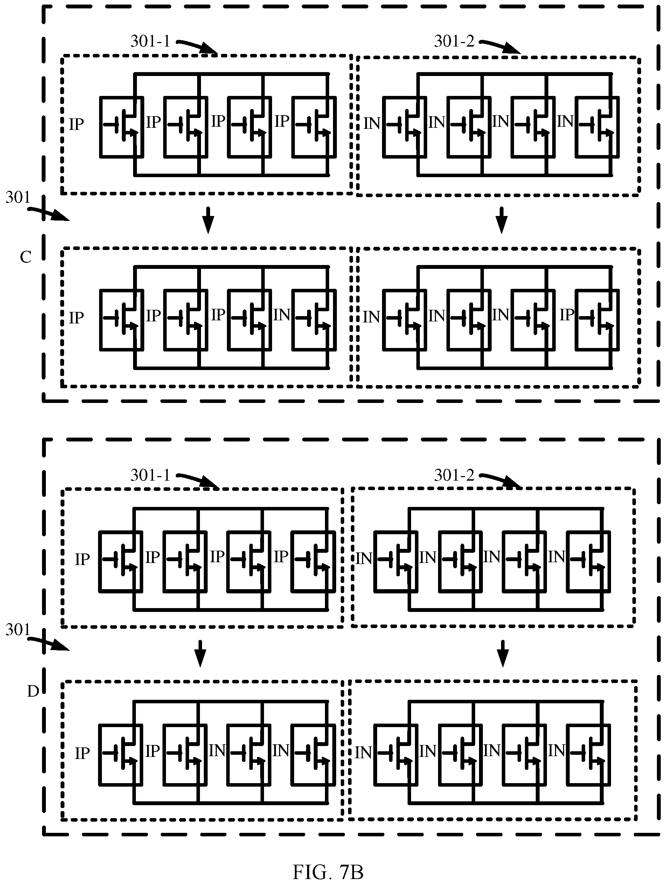

Refer to FIG. 7A and FIG. 7B together. FIG. 7A is a schematic adjustment diagram of a conventional gain adjustment method, and FIG. 7B is a schematic adjustment diagram of an operational amplifier according to an embodiment of this application.

It can be learned from formula (1) that a gain A_{dc_tot} in the conventional method is directly proportional to (W*I_{bias})^{1/2}. In the description of this application, one switching transistor in the conventional technology is equivalent to a plurality of switching transistors, to better represent a change of W of the switching transistor in an adjustment process.

In the conventional method, when a gain is halved through adjustment, in a possible implementation, a solution A is used, a width-to-length ratio of an input transistor needs to be reduced from 4 to 1, an adjustment step of this manner is non-linear, an exponential change relationship is present, a size of the input transistor is greatly changed, and adjustment efficiency is low; or in another possible implementation, a solution B is used, a width-to-length ratio of an input transistor is reduced from 4 to 2, and a tail current is reduced by half. In this case, it can be learned from formula (2) that a direct-current operating point changes, and consequently normal operating of the operational amplifier is affected.

However, when the solution of this application is applied, in a possible implementation, a symmetric adjustment manner shown in C is used. Using an example in which in an initial state, four input adjustment units in a first switching transistor group 301-1 are connected to IP and four input adjustment units in a second switching transistor group 301-2 are connected to IN, when the gain needs to be halved through adjustment, an input signal of one input adjustment unit in the first switching transistor group 301-1 is switched from IP to IN, and an input signal of one input adjustment unit in the second switching transistor group 301-2 is symmetrically switched from IN to IP, to complete adjustment.

In another possible implementation, an asymmetric adjustment manner shown in D is used, input signals of a second switching transistor group 301-2 are kept unchanged, and input signals of two input adjustment units in a first switching transistor group 301-1 are switched from IP to IN, to complete adjustment.

The above two methods achieve gain halving, but do not change the size of the input transistor, the load, the tail current, positions of the operating point, the zero point and the pole of the operational amplifier, the adjustment solutions are simple, the area of the input transistor and the overhead of power consumption are not increased, and the gain adjustment efficiency is high.

In addition, the foregoing adjustment implements gain adjustment. Alternatively, a similar manner may be used, a load may be adjusted to control proportions of two or more input signals, to perform linear adjustment on parameters such as an equivalent transconductance, an equivalent current, and an equivalent impedance. Detailed descriptions are made below with reference to accompanying drawings.

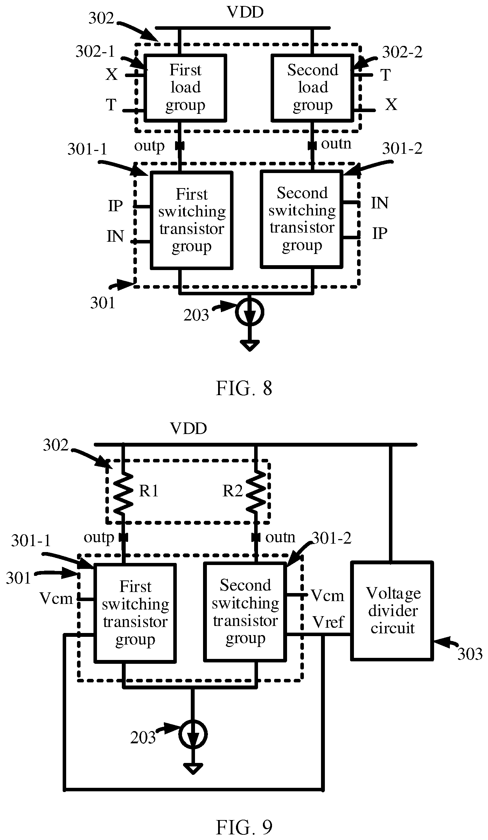

FIG. 8A is a schematic diagram of another operational amplifier according to an embodiment of this application.

As shown in the figure, for the operational amplifier, a first load is a first load group 302-1 and a second load is a second load group 302-2.

The first load group 302-1 and the second load group 302-2 include a same quantity of at least two load adjustment units 402.

The first load group 302-1 and the second load group 302-2 are configured to adjust quantities of respective load adjustment units connected to input signals.

In this embodiment, two input signals are respectively represented by X and T.

In this case, parameters such as an equivalent transconductance, an equivalent current, and an equivalent impedance of the operational amplifier can be linearly adjusted by adjusting the input signals connected to the load adjustment units. A specific implementation and an adjustment principle of the load adjustment unit are similar to those described in the foregoing embodiments, and details are not described herein again in this application.

In a typical application scenario, the operational amplifier provided in this embodiment of this application is applied to feedback adjustment on a common-mode signal. In this case, the input signal includes a common-mode signal and a reference signal.

In some embodiments, the common-mode signal is generated by a low voltage differential signal generation circuit, and the reference signal may be input by an external circuit, or may be obtained through voltage division of a power supply. An example in which the first input signal is the reference signal is used below for description.

FIG. 9 is a schematic diagram of another operational amplifier according to an embodiment of this application.

In this case, the operational amplifier further includes a voltage divider circuit 303, an input end of the voltage divider circuit is connected to a power supply VDD of the operational amplifier, and an output end of the voltage divider circuit 303 is configured to output a reference signal Vref.

The voltage divider circuit 303 is configured to convert a voltage provided by the power supply VDD into the reference signal Vref.

Based on the operational amplifier provided in the foregoing embodiments, an embodiment of this application further provides a low voltage differential signal drive circuit which is specifically described below with reference to an accompanying drawing.

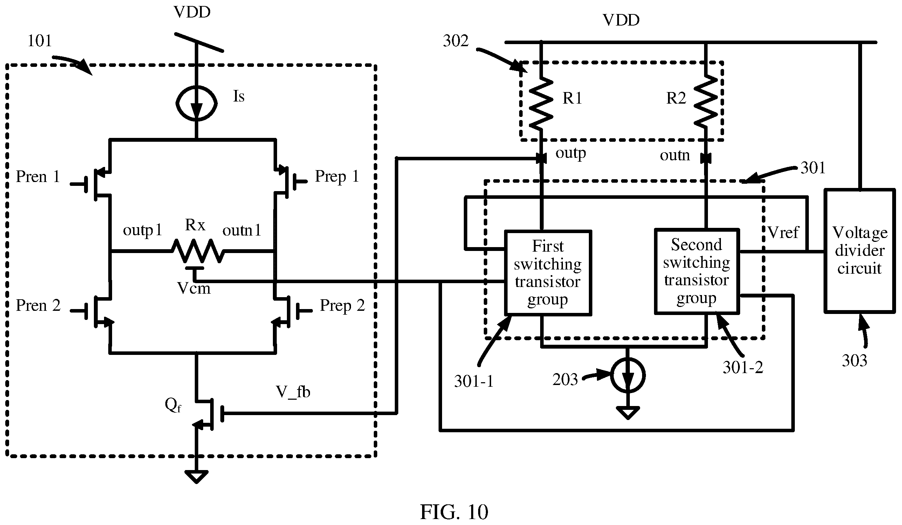

FIG. 10 is a schematic diagram of a low voltage differential signal drive circuit according to an embodiment of this application.

As shown in the figure, the low voltage differential signal drive circuit includes the operational amplifier provided in the foregoing embodiments, and further includes a low voltage differential signal generation circuit 101.

An input end of the low voltage differential signal generation circuit 101 is connected to a power supply VDD, and a feedback signal end of the low voltage differential signal generation circuit is connected to a first output end outp of the operational amplifier or a second output end outn of the operational amplifier, and is connected to, for example, the first output end outp in the figure.

A common-mode signal Vcm output by the low voltage differential signal generation circuit 101 is a first input signal of the operational amplifier, and is, for example, the input signal IP in the foregoing embodiments.

Output ends outp1 and outn1 of the low voltage differential signal generation circuit 101 are configured to output low voltage differential signals.

A reference signal Vref is a second input signal of the operational amplifier, and is, for example, the input signal IN in the foregoing embodiments. The reference signal may be input by an external circuit, or may be obtained through voltage division of the power supply VDD.

In FIG. 10, an example in which the reference signal is obtained through voltage division of the power supply VDD is used. In this case, the operational amplifier further includes a voltage divider circuit 303, an input end of the voltage divider circuit 303 is connected to the power supply VDD, and an output end of the voltage divider circuit is configured to output the reference signal Vref.

The voltage divider circuit 303 is configured to convert a voltage provided by the power supply VDD into the reference signal Vref.

For a principle of the low voltage differential signal generation circuit 101, refer to the description corresponding to FIG. 1. The principle is a mature technology in the art, and details are not described herein again in this embodiment of this application. For an implementation and an operating principle of the operational amplifier, refer to the related description in the foregoing embodiments, and details are not described herein again.

In conclusion, the low voltage differential signal generation circuit adjusts, by using the operational amplifier, a common-mode level Vcm with a change of a reference voltage Vref, to satisfy a multi-scenario and multi-protocol requirement. The operational amplifier adjusts types of the input signals connected to the input adjustment units in the first switching transistor group and the second switching transistor group, to adjust proportions of the input signals of the operational amplifier, and further adjust a gain of the operational amplifier. An input end of each input adjustment unit is connected to only one input signal, and a quantity of adjustment units does not change in an adjustment process. Therefore, a gain can be linearly adjusted, and a size, a load, a tail current, a direct-current operating point, and an output pole of a switching transistor group are not changed in an adjustment process. In addition, because the size of the switching transistor group is not increased in the adjustment process, that is, an area of the switching transistor group and power consumption are not increased, gain adjustment efficiency is further improved.

Based on the operational amplifier provided in the foregoing embodiments, an embodiment of this application further provides a gain adjustment method for an operational amplifier. The method is specifically described below with reference to an accompanying drawing.

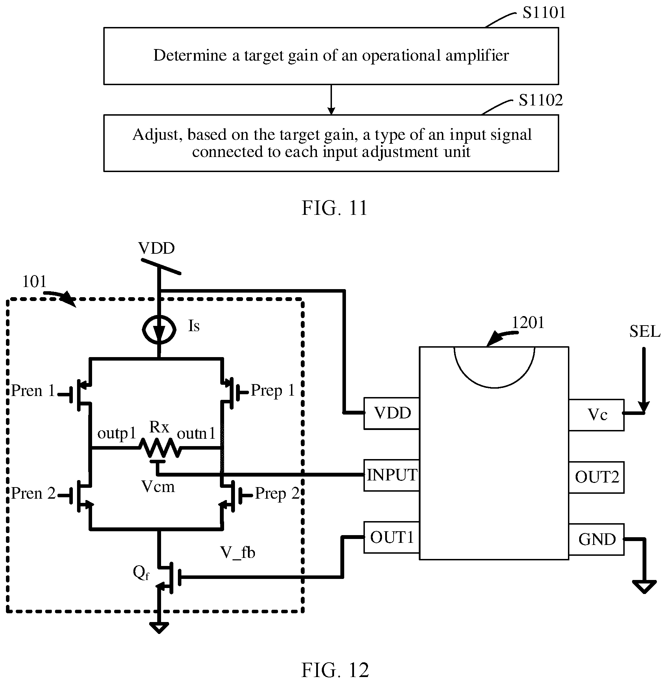

FIG. 11 is a flowchart of a gain adjustment method for an operational amplifier according to an embodiment of this application.

The method is applied to the operational amplifier provided in the foregoing embodiments. For a specific implementation of the operational amplifier, refer to the related description in the foregoing embodiments. Details are not described herein again.

The method includes the following steps:
S1101: Determine a target gain of an operational amplifier.

S1102: Adjust, based on the target gain, a type of an input signal connected to each input adjustment unit.

In a possible implementation, when the symmetric adjustment manner is used, in a first switching transistor group, a first quantity of input adjustment units is connected to a first input signal, and a second quantity of input adjustment units is connected to a second input signal; and in the second switching transistor group, the second quantity of input adjustment units is connected to the first input signal, and the first quantity of input adjustment units is connected to the second input signal; and
the first quantity is not equal to the second quantity. The first quantity is M, the second quantity is N, and both M and N are integers greater than or equal to 0. After current values of M and N are determined based on the target gain, corresponding adjustment is performed on the input adjustment units in the first switching transistor group and the second switching transistor group through a corresponding adjustment signal, to linearly adjust a gain of the operational amplifier.

In another possible implementation, when the asymmetric adjustment manner is used, in a first switching transistor group, a first quantity of input adjustment units is connected to a first input signal, and a second quantity of input adjustment units is connected to a second input signal; and A third quantity of input adjustment units in the second switching transistor group 301-2 is connected to the first input signal.

The first quantity is M, the second quantity is N, M is an integer greater than or equal to 0, N is an integer greater than 0, and the third quantity is equal to a sum of the first quantity and the second quantity. After current values of M and N are determined based on the target gain, corresponding adjustment is performed on the input adjustment units in the first switching transistor group and the second switching transistor group through a corresponding adjustment signal, to linearly adjust a gain of the operational amplifier.

In conclusion, the method provided in this embodiment of this application is used to linearly adjust the gain of the operational amplifier according to a method for adjusting a state of an input switching transistor, and then controlling proportions of two or more input signals, so that the gain can be linearly adjusted. Moreover, a direct-current operating point and an output pole of the circuit are not changed, and stability and adjustment effect are improved.

Based on the operational amplifier provided in the foregoing embodiments, an embodiment of this application further provides an interface chip integrated with the operational amplifier provided in the foregoing embodiments. The interface chip is specifically described below with reference to an accompanying drawing.

FIG. 12 is a schematic diagram of an interface chip according to an embodiment of this application.

The interface chip 1201 shown in the figure includes the operational amplifier provided in the foregoing embodiments. Package pin ports of the interface chip include: a power port VDD, a first output port OUT1, a second output port OUT2, a grounding port GND, a control port Vc, and a first input port INPUT.

The operational amplifier is connected to the power supply by using the power port, the operational amplifier is grounded by using the grounding port, a first output end of the operational amplifier is connected to the first output port, and a second output end of the operational amplifier is connected to the second output port. In practical application, the first output port OUT1 or the second output port OUT2 is configured to output a feedback signal V_fb. In this embodiment of this application, an example in which OUT1 outputs the feedback signal V_fb is used.

The first input port is connected to a common-mode signal Vcm, and the common-mode signal is a first input signal.

The first switching transistor group and the second switching transistor group obtain an adjustment signal SEL through the control port Vc. Each input adjustment unit adjusts, based on the adjustment signal SEL, a type of an input signal connected to the input adjustment unit.

In this case, the operational amplifier is integrated into the interface chip 1201, and is used as a peripheral circuit of a low voltage differential signal generation circuit 101. The low voltage differential signal generation circuit 101 adjusts, by using the interface chip 1201, a common-mode level Vcm with a change of a reference voltage Vref, to satisfy a multi-scenario and multi-protocol requirement.

The interface chip 1201 is further integrated with a voltage divider circuit, an input end of the voltage divider circuit is connected to the power port, an output end of the voltage divider circuit is configured to output the reference signal, and the reference signal is the second input signal. The voltage divider circuit is configured to convert a voltage provided by the power supply into the reference signal to serve as an input signal generated inside the interface chip 1201.

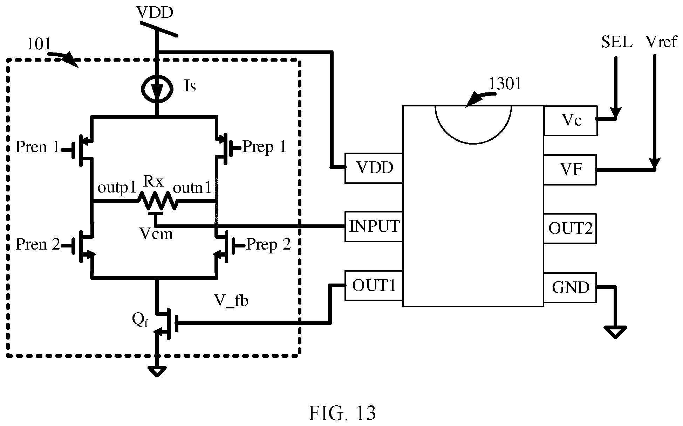

FIG. 13 is a schematic diagram of another interface chip according to an embodiment of this application.

Different from 1201, the interface chip 1301 shown in FIG. 13 further includes a reference input port VF.

The reference input port VF is configured to connect to a reference signal Vref, and the reference signal is a second input signal. To be specific, the reference signal Vref is not generated inside the interface chip 1301, but is input through an external circuit.

In conclusion, the interface chip provided in this embodiment of this application is used to linearly adjust a gain, and a size, a load, and a tail current of the switching transistor group are not changed in the adjustment process. Therefore, a direct-current operating point and an output pole of the operational amplifier are not changed. Because a size of the switching transistor group is not increased in the adjustment process, that is, an area of the switching transistor group and power consumption are not increased, gain adjustment efficiency is further improved.

Based on the operational amplifier provided in the foregoing embodiments, an embodiment of this application further provides an interface chip integrated with the low voltage differential signal drive circuit provided in the foregoing embodiments. The interface chip is specifically described below with reference to an accompanying drawing.

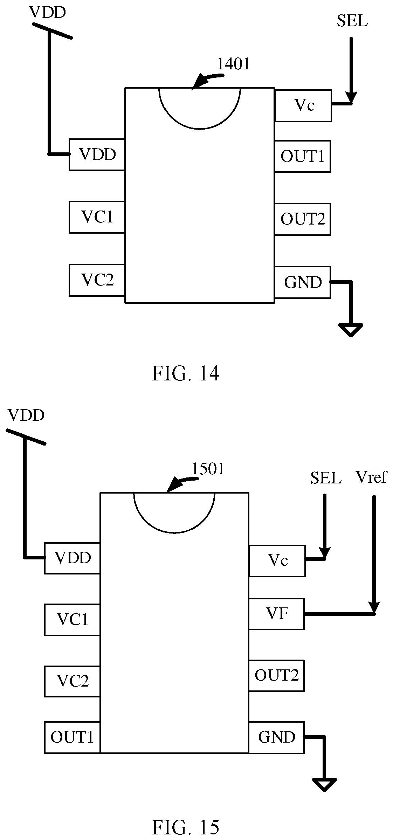

FIG. 14 is a schematic diagram of still another interface chip according to an embodiment of this application.

The interface chip 1401 shown in the figure includes the operational amplifier and the low voltage differential signal generation circuit that are provided in the foregoing embodiments. Package pin ports of the interface chip include: a power port VDD, a first control port VC1, a second control port VC2, a third control port Vc, a grounding port GND, and output ports OUT1 and OUT2.

The low voltage differential signal generation circuit and the operational amplifier are connected to the power supply by using the power port, and are grounded by using the grounding port.

For specific implementations and operating principles of the low voltage differential signal generation circuit and the operational amplifier, refer to the foregoing description, and details are not described herein again.

The low voltage differential signal generation circuit obtains a control signal from the first control port VC1 and the second control port VC2, generates a low voltage differential signal based on the control signal, and outputs the low voltage differential signal through the output port.

The first switching transistor group and the second switching transistor group obtain an adjustment signal SEL through the third control port Vc, and adjust, based on the adjustment signal, quantities of respective input adjustment units connected to input signals.

The interface chip 1401 is further integrated with a voltage divider circuit, an input end of the voltage divider circuit is connected to the power port, an output end of the voltage divider circuit is configured to output the reference signal, and the reference signal is the second input signal. The voltage divider circuit is configured to convert a voltage provided by the power supply into the reference signal to serve as an input signal generated inside the interface chip 1401.

In some embodiments, only one of the foregoing output ports OUT1 and OUT2 may alternatively be disposed.

FIG. 15 is a schematic diagram of yet another interface chip according to an embodiment of this application.

Different from 1401, the interface chip 1501 shown in FIG. 15 further includes a reference input port VF.

The reference input port VF is configured to connect to a reference signal Vref, and the reference signal is a second input signal. To be specific, the reference signal Vref is not generated inside the interface chip 1301, but is input through an external circuit.

In conclusion, through the interface chip provided in this embodiment of this application, the low voltage differential signal generation circuit and the operational amplifier are integrated together, a gain can be linearly adjusted, and a size, a load, and a tail current of the switching transistor group are not changed in the adjustment process. Therefore, a direct-current operating point and an output pole of the operational amplifier are not changed. Because a size of the switching transistor group is not increased in the adjustment process, that is, an area of the switching transistor group and power consumption are not increased, gain adjustment efficiency is further improved.

Based on the operational amplifier and the low voltage differential signal drive circuit that are provided in the foregoing embodiments, an embodiment of this application further provides an electronic device which is specifically described below with reference to an accompanying drawing.

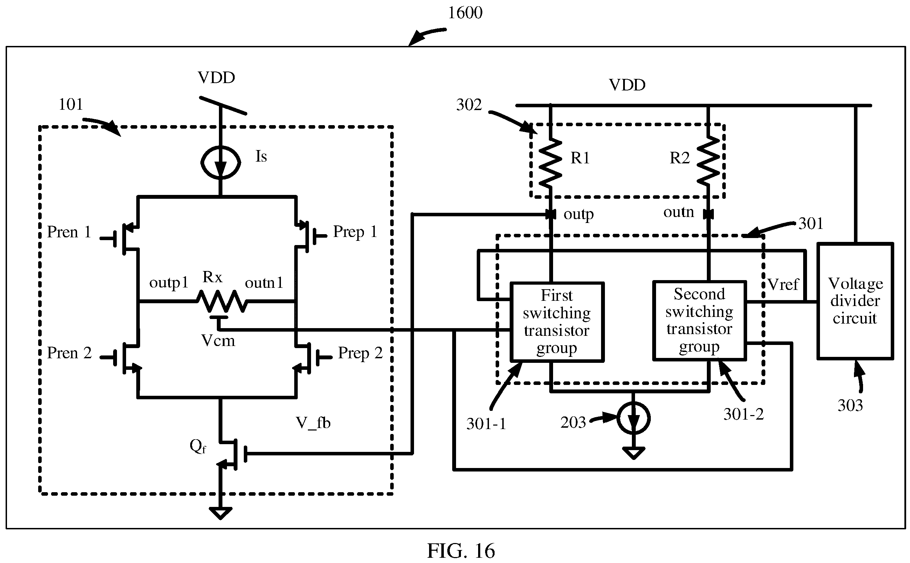

FIG. 16 is a schematic diagram of an electronic device according to an embodiment of this application.

The electronic device 1600 shown in the figure includes the operational amplifier and the low voltage differential signal drive circuit 101 that are provided in the foregoing embodiments. For a specific implementation and an operating principle of the operational amplifier, refer to related descriptions in the foregoing embodiments. Details are not described herein again in this embodiment of this application.

The electronic device 1600 further includes a controller (not shown in the figure), and the controller may be an ASIC, a PLC, a DSP, or a combination thereof. The PLD may be a CPLD, an FPGA, a GAL, or any combination thereof. This is not specifically limited in this embodiment of this application.

The controller is configured to send a control signal to two pairs of switching transistors Pren1 and Prep1 and Pren2 and Prep2 of the low voltage differential signal drive circuit 101, so that the low voltage differential signal drive circuit 101 generates and outputs a low voltage differential signal. The controller is further configured to send an adjustment signal to the first selector switch based on the target gain, so that the first switching transistor group 301-1 and the second switching transistor group 301-2 adjust quantities of respective input adjustment units connected to input signals.

A type of the electronic device is not specifically limited in this embodiment of this application. For example, the electronic device may be a display device, a monitoring device, a vehicle communication device, an industrial control device, or the like.

In conclusion, the operational amplifier of the electronic device adjusts the input signals connected to the input adjustment units in the first switching transistor group and the second switching transistor group, to adjust proportions of the input signals of the operational amplifier, and further adjust a gain of the operational amplifier. An input end of each input adjustment unit is connected to only one input signal, and a quantity of adjustment units does not change in an adjustment process. Therefore, a gain can be linearly adjusted, and a size, a load, a tail current, a direct-current operating point, and an output pole of a switching transistor group are not changed in an adjustment process. In addition, because the size of the switching transistor group is not increased in the adjustment process, that is, an area of the switching transistor group and power consumption are not increased, gain adjustment efficiency is further improved.

Based on the foregoing electronic device, an embodiment of this application further provides a gain adjustment method for an operational amplifier. The method is specifically described below.

FIG. 17 is a flowchart of a gain adjustment method for an operational amplifier according to an embodiment of this application.

The method may be implemented by a controller of an electronic device, and specifically includes the following steps:
S1701: Determine a target parameter value.

S1702: Determine an adjustment signal based on the target parameter value, and send the adjustment signal to the first switching transistor group and the second switching transistor group, where the adjustment signal is for indicating the first switching transistor group and the second switching transistor group to adjust quantities of respective input adjustment units connected to input signals.

The target parameter value may be a gain of the operational amplifier.

It should be understood that in this application, "at least one (item)" refers to one or more, and "a plurality of" refers to two or more. "and/or" is used to describe an association relationship between associated objects, and indicates that three relationships may exist. For example, "A and/or B" may indicate that only A exists, only B exists, and both A and B exist, where A and B may be singular or plural. The character "/" generally indicates that the associated objects are in an OR relationship. "At least one of the following" or a similar expression thereof refers to any combination of these items, including any combination of a single item or a plural item. For example, at least one () of a, b, or c may represent: a, b, c, "a and b", "a and c", "b and c", or "a and b and c", where a and b, c can be a single or multiple.

## Claims

1. An operational amplifier, wherein the operational amplifier comprises: a first load (R1), a second load (R2), a first switching transistor group (301-1), and a second switching transistor group (301-2);
a first end of the first switching transistor group (301-1) is connected to a first output end of the operational amplifier, and is connected to a power supply (VDD) of the operational amplifier by using the first load (R1), and a second end of the first switching transistor group (301-1) is grounded;
a first end of the second switching transistor group (301-2) is connected to a second output end of the operational amplifier, and is connected to the power supply (VDD) by using the second load (R2), and a second end of the second switching transistor group (301-2) is grounded;
the first switching transistor group (301-1) and the second switching transistor group (301-2) comprise a same quantity of at least two input adjustment units (401), and an input end of each of the input adjustment units (401) is connected to an input signal;
wherein each of the input adjustment units (401) comprises a first selector switch (S) and a first switching transistor (Q);
the first selector switch (S) is connected to a control end of the first switching transistor (Q); and
the first selector switch (S) is configured to select an input signal to be connected to the control end of the first switching transistor (Q),
wherein a first end of the first switching transistor of each of the input adjustment units of the first switching transistor group (301-1) is directly connected to the first end of the first switching transistor group (301-1), wherein a first end of the first switching transistor of each of the input adjustment units of the second switching transistor group (301-2) is directly connected to the first end of the second switching transistor group (301-2),
wherein the input signal comprises the following two signals: a first input signal and a second input signal;
wherein in a first quantity of input adjustment units (401) in the first switching transistor group (301-1), the first selector switches (S) connect the control ends of the first switching transistors (Q) to the first input signal, and in a second quantity of input adjustment units (401) in the first switching transistor group (301-1), the first selector switches (S) connect the control ends of the first switching transistors (Q) to the second input signal;
wherein in a third quantity of input adjustment units (401) in the second switching transistor group (301-2), the first selector switches (S) connect the control ends of the first switching transistors (Q) to the first input signal, wherein
the operational amplifier further comprises a tail current source (203), the second ends of the first switching transistor group (301-1) and of the second switching transistor group (301-2) are grounded by using the tail current source (203);
wherein the third quantity is equal to a sum of the first quantity and the second quantity.

2. The operational amplifier according to claim 1, wherein the first selector switch (S) selects a to-be-connected input signal based on an adjustment signal (SEL); and
the first selector switch selects to connect to the first input signal when the adjustment signal is a first level; or the first selector switch selects to connect to the second input signal when the adjustment signal is a second level.

3. The operational amplifier according to claim 1, wherein the first selector switch (S) selects a to-be-connected input signal based on an adjustment signal; and
the first selector switch (S) of the first switching transistor group (301-1) selects to connect to the first input signal when the adjustment signal (SEL) is a first level or selects to connect to a second input signal when the adjustment signal (SEL) is a second level; and
the first selector switch (S) of the second switching transistor group (301-2) selects to connect to the first input signal when the adjustment signal (SEL) is a second level or selects to connect to the second input signal when the adjustment signal (SEL) is a first level.

4. The operational amplifier according to any one of claims 1 to 3, wherein
the first input signal a common-mode signal, and the second input signal is a reference signal (Vref).

5. The operational amplifier according to claim 4, wherein the operational amplifier further comprises a voltage divider circuit (303), an input end of the voltage divider circuit (303) is connected to the power supply (VDD) of the operational amplifier, and an output end of the voltage divider circuit (303) is configured to output the reference signal (Vref); and
the voltage divider circuit (303) is configured to convert a voltage provided by the power supply (VDD) into the reference signal (Vref).

6. A low voltage differential signal drive circuit (101), wherein the low voltage differential signal drive circuit comprises the operational amplifier according to any one of claims 1 to 5, and further comprises a low voltage differential signal generation circuit;
an input end of the low voltage differential signal generation circuit is connected to the power supply (VDD), and a feedback signal end of the low voltage differential signal generation circuit is connected to the first output end of the operational amplifier or the second output end of the operational amplifier;
the low voltage differential signal generation circuit is configured to output a common-mode signal, and the common-mode signal is a first input signal of the operational amplifier; and
an output end of the low voltage differential signal generation circuit is configured to output a low voltage differential signal.

7. The low voltage differential signal drive circuit according to claim 6 comprising the operational amplifier according to claim 6, wherein a reference signal (Vref) is a second input signal of the operational amplifier.

8. A gain adjustment method for the operational amplifier according to claim 2, wherein the method comprises:
determining (S1101) a target gain; and
determining (S1102) the adjustment signal (SEL) based on the target gain, and sending the adjustment signal (SEL) to the first selector switches (S).

9. An interface chip (1201, 1301, 1401, 1501), wherein the interface chip comprises the operational amplifier according to any one of claims 1 to 5, and the interface chip comprises a power port (VDD), a first output port (OUT1), a second output port (OUT2), a grounding port (GND), a control port (Vc), and a first input port (INPUT);
the operational amplifier is connected to the power supply (VDD) by using the power port (VDD), the operational amplifier is grounded by using the grounding port (GND), a first output end of the operational amplifier is connected to the first output port (OUT1), and a second output end of the operational amplifier is connected to the second output port(OUT2);
the first input port (INPUT) is connected to a common-mode signal, and the common-mode signal is a first input signal of the operational amplifier; and
the first switching transistor group (301-1) and the second switching transistor group (301-2) obtain an adjustment signal (SEL) through the control port (Vc).

10. The interface chip (1301, 1501) according to claim 9, wherein the interface chip further comprises a reference input port (VF); and
the reference input port (VF) is configured to connect to a reference signal (Vref), and the reference signal (Vref) is a second input signal.

11. An electronic device, wherein the electronic device comprises the interface chip according to claim 9 or 10.

## Patentansprüche

1. Operationsverstärker, wobei der Operationsverstärker umfasst: eine erste Last (R1), eine zweite Last (R2), eine erste Schalttransistorgruppe (301-1) und eine zweite Schalttransistorgruppe (301-2);
ein erstes Ende der ersten Schalttransistorgruppe (301-1) mit einem ersten Ausgangsende des Operationsverstärkers verbunden ist und unter Verwendung der ersten Last (R1) mit einer Leistungsversorgung (VDD) des Operationsverstärkers verbunden ist, und ein zweites Ende der ersten Schalttransistorgruppe (301-1) geerdet ist; ein erstes Ende der zweiten Schalttransistorgruppe (301-2) mit einem zweiten Ausgangsende des Operationsverstärkers verbunden ist und unter Verwendung der zweiten Last (R2) mit der Leistungsversorgung (VDD) verbunden ist, und ein zweites Ende der zweiten Schalttransistorgruppe (301-2) geerdet ist;
die erste Schalttransistorgruppe (301-1) und die zweite Schalttransistorgruppe (301-2) eine gleiche Anzahl von mindestens zwei Eingangseinstelleinheiten (401) umfassen, und ein Eingangsende jeder der Eingangseinstelleinheiten (401) mit einem Eingangssignal verbunden ist;
wobei jede der Eingangseinstelleinheiten (401) einen ersten Wahlschalter (S) und einen ersten Schalttransistor (Q) umfasst;
der erste Wahlschalter (S) mit einem Steuerende des ersten Schalttransistors (Q) verbunden ist; und der erste Wahlschalter (S) konfiguriert ist, um ein Eingangssignal auszuwählen, das mit dem Steuerende des ersten Schalttransistors (Q) verbunden werden soll,
wobei ein erstes Ende des ersten Schalttransistors jeder der Eingangseinstelleinheiten der ersten Schalttransistorgruppe (301-1) direkt mit dem ersten Ende der ersten Schalttransistorgruppe (301-1) verbunden ist, wobei ein erstes Ende des ersten Schalttransistors jeder der Eingangseinstelleinheiten der zweiten Schalttransistorgruppe (301-2) direkt mit dem ersten Ende der zweiten Schalttransistorgruppe (301-2) verbunden ist,
wobei das Eingangssignal die folgenden zwei Signale umfasst: ein erstes Eingangssignal und ein zweites Eingangssignal;
wobei in einer ersten Anzahl von Eingangseinstelleinheiten (401) in der ersten Schalttransistorgruppe (301-1) die ersten Wahlschalter (S) die Steuerenden der ersten Schalttransistoren (Q) mit dem ersten Eingangssignal verbinden, und in einer zweiten Anzahl von Eingangseinstelleinheiten (401) in der ersten Schalttransistorgruppe (301-1) die ersten Wahlschalter (S) die Steuerenden der ersten Schalttransistoren (Q) mit dem zweiten Eingangssignal verbinden; wobei in einer dritten Anzahl von Eingangseinstelleinheiten (401) in der zweiten Schalttransistorgruppe (301-2) die ersten Wahlschalter (S) die Steuerenden der ersten Schalttransistoren (Q) mit dem ersten Eingangssignal verbinden, wobei der Operationsverstärker ferner eine Schwanzstromquelle (203) umfasst, die zweiten Enden der ersten Schalttransistorgruppe (301-1) und der zweiten Schalttransistorgruppe (301-2) unter Verwendung der Schwanzstromquelle (203) geerdet sind;
wobei die dritte Anzahl gleich einer Summe aus der ersten Anzahl und der zweiten Anzahl ist.

2. Operationsverstärker nach Anspruch 1, wobei der erste Wahlschalter (S) ein anzuschließendes Eingangssignal basierend auf einem Einstellsignal (SEL) auswählt; und der erste Wahlschalter auswählt, mit dem ersten Eingangssignal zu verbinden, wenn das Einstellsignal ein erster Pegel ist; oder der erste Wahlschalter auswählt, mit dem zweiten Eingangssignal zu verbinden, wenn das Einstellsignal ein zweiter Pegel ist.

3. Operationsverstärker nach Anspruch 1, wobei der erste Wahlschalter (S) ein anzuschließendes Eingangssignal basierend auf einem Einstellsignal auswählt; und der erste Wahlschalter (S) der ersten Schalttransistorgruppe (301-1) auswählt, mit dem ersten Eingangssignal zu verbinden, wenn das Einstellsignal (SEL) ein erster Pegel ist, oder auswählt, mit einem zweiten Eingangssignal zu verbinden, wenn das Einstellsignal (SEL) ein zweiter Pegel ist; und
der erste Wahlschalter (S) der zweiten Schalttransistorgruppe (301-2) auswählt, mit dem ersten Eingangssignal zu verbinden, wenn das Einstellsignal (SEL) ein zweiter Pegel ist, oder auswählt, mit dem zweiten Eingangssignal zu verbinden, wenn das Einstellsignal (SEL) ein erster Pegel ist.

4. Operationsverstärker nach einem der Ansprüche 1 bis 3, wobei das erste Eingangssignal ein Gleichtaktsignal ist und das zweite Eingangssignal ein Referenzsignal (Vref) ist.

5. Operationsverstärker nach Anspruch 4, wobei der Operationsverstärker ferner eine Spannungsteilerschaltung (303) umfasst, ein Eingangsende der Spannungsteilerschaltung (303) mit der Leistungsversorgung (VDD) des Operationsverstärkers verbunden ist und ein Ausgangsende der Spannungsteilerschaltung (303) konfiguriert ist, um das Referenzsignal (Vref) auszugeben; und
die Spannungsteilerschaltung (303) konfiguriert ist, um eine von der Leistungsversorgung (VDD) bereitgestellte Spannung in das Referenzsignal (Vref) umzuwandeln.

6. Niederspannungs-Differenzsignal-Treiberschaltung (101), wobei die Niederspannungs-Differenzsignal-Treiberschaltung den Operationsverstärker nach einem der Ansprüche 1 bis 5 umfasst und ferner eine Niederspannungs-Differenzsignal-Erzeugungsschaltung umfasst;
ein Eingangsende der Niederspannungs-Differenzsignal-Erzeugungsschaltung mit der Leistungsversorgung (VDD) verbunden ist, und ein Rückkopplungssignalende der Niederspannungs-Differenzsignal-Erzeugungsschaltung mit dem ersten Ausgangsende des Operationsverstärkers oder dem zweiten Ausgangsende des Operationsverstärkers verbunden ist;
die Niederspannungs-Differenzsignal-Erzeugungsschaltung konfiguriert ist, um ein Gleichtaktsignal auszugeben, und das Gleichtaktsignal ein erstes Eingangssignal des Operationsverstärkers ist; und
ein Ausgangsende der Niederspannungs-Differenzsignal-Erzeugungsschaltung konfiguriert ist, um ein Niederspannungs-Differenzsignal auszugeben.

7. Niederspannungs-Differenzsignal-Treiberschaltung nach Anspruch 6, die den Operationsverstärker nach Anspruch 6 umfasst, wobei ein Referenzsignal (Vref) ein zweites Eingangssignal des Operationsverstärkers ist.

8. Verstärkungseinstellungsverfahren für den Operationsverstärker nach Anspruch 2, wobei das Verfahren umfasst:
Bestimmen (S1101) einer Zielverstärkung; und
Bestimmen (S1102) des Einstellsignals (SEL) basierend auf der Zielverstärkung und Senden des Einstellsignals (SEL) an die ersten Wahlschalter (S).

9. Schnittstellenchip (1201, 1301, 1401, 1501), wobei der Schnittstellenchip den Operationsverstärker nach einem der Ansprüche 1 bis 5 umfasst, und der Schnittstellenchip einen Leistungsanschluss (VDD), einen ersten
Ausgangsanschluss (OUT1), einen zweiten Ausgangsanschluss (OUT2), einen Erdungsanschluss (GND), einen Steueranschluss (Vc) und einen ersten Eingangsanschluss (INPUT) umfasst;
der Operationsverstärker unter Verwendung des Leistungsanschlusses (VDD) mit der Leistungsversorgung (VDD) verbunden ist, der Operationsverstärker unter Verwendung des Erdungsanschlusses (GND) geerdet ist, ein erstes Ausgangsende des Operationsverstärkers mit dem ersten Ausgangsanschluss (OUT1) verbunden ist, und ein zweites Ausgangsende des Operationsverstärkers mit dem zweiten Ausgangsanschluss (OUT2) verbunden ist;
der erste Eingangsanschluss (INPUT) mit einem Gleichtaktsignal verbunden ist, und das Gleichtaktsignal ein erstes Eingangssignal des Operationsverstärkers ist; und die erste Schalttransistorgruppe (301-1) und die zweite Schalttransistorgruppe (301-2) ein Einstellsignal (SEL) über den Steueranschluss (Vc) erhalten.

10. Schnittstellenchip (1301, 1501) nach Anspruch 9, wobei der Schnittstellenchip ferner einen Referenzeingangsanschluss (VF) umfasst; und
der Referenzeingangsanschluss (VF) konfiguriert ist, um mit einem Referenzsignal (Vref) verbunden zu werden, und das Referenzsignal (Vref) ein zweites Eingangssignal ist.

11. Elektronische Vorrichtung, wobei die elektronische Vorrichtung den Schnittstellenchip nach Anspruch 9 oder 10 umfasst.

## Revendications

1. Amplificateur opérationnel, dans lequel l'amplificateur opérationnel comprend : une première charge (R1), une seconde charge (R2), un premier groupe de transistors de commutation (301-1), et un second groupe de transistors de commutation (301-2) ; une première extrémité du premier groupe de transistors de commutation (301-1) est connectée à une première extrémité de sortie de l'amplificateur opérationnel, et est connectée à une alimentation électrique (VDD) de l'amplificateur opérationnel en utilisant la première charge (R1), et une seconde extrémité du premier groupe de transistors de commutation (301-1) est mise à la terre ;
une première extrémité du second groupe de transistors de commutation (301-2) est connectée à une seconde extrémité de sortie de l'amplificateur opérationnel, et est connectée à l'alimentation électrique (VDD) en utilisant la seconde charge (R2), et une seconde extrémité du second groupe de transistors de commutation (301-2) est mise à la terre ;
le premier groupe de transistors de commutation (301-1) et le second groupe de transistors de commutation (301-2) comprennent une même quantité d'au moins deux unités de réglage d'entrée (401), et une extrémité d'entrée de chacune des unités de réglage d'entrée (401) est connectée à un signal d'entrée ;
dans lequel chacune des unités de réglage d'entrée (401) comprend un premier commutateur de sélection (S) et un premier transistor de commutation (Q) ;
le premier commutateur de sélection (S) est connecté à une extrémité de commande du premier transistor de commutation (Q) ; et
le premier commutateur de sélection (S) est configuré pour sélectionner un signal d'entrée à connecter à l'extrémité de commande du premier transistor de commutation (Q),
dans lequel une première extrémité du premier transistor de commutation de chacune des unités de réglage d'entrée du premier groupe de transistors de commutation (301-1) est directement connectée à la première extrémité du premier groupe de transistors de commutation (301-1),
dans lequel une première extrémité du premier transistor de commutation de chacune des unités de réglage d'entrée du second groupe de transistors de commutation (301-2) est directement connectée à la première extrémité du second groupe de transistors de commutation (301-2),
dans lequel le signal d'entrée comprend les deux signaux suivants : un premier signal d'entrée et un second signal d'entrée ;
dans lequel, dans une première quantité d'unités de réglage d'entrée (401) dans le premier groupe de transistors de commutation (301-1), les premiers commutateurs de sélection (S) connectent les extrémités de commande des premiers transistors de commutation (Q) au premier signal d'entrée, et dans une deuxième quantité d'unités de réglage d'entrée (401) dans le premier groupe de transistors de commutation (301-1), les premiers commutateurs de sélection (S) connectent les extrémités de commande des premiers transistors de commutation (Q) au second signal d'entrée ;
dans lequel dans une troisième quantité d'unités de réglage d'entrée (401) dans le second groupe de transistors de commutation (301-2), les premiers commutateurs de sélection (S) connectent les extrémités de commande des premiers transistors de commutation (Q) au premier signal d'entrée, dans lequel
l'amplificateur opérationnel comprend en outre une source de courant de queue (203), les secondes extrémités du premier groupe de transistors de commutation (301-1) et du second groupe de transistors de commutation (301-2) sont mises à la terre en utilisant la source de courant de queue (203) ;
dans lequel la troisième quantité est égale à une somme de la première quantité et de la deuxième quantité.

2. Amplificateur opérationnel selon la revendication 1, dans lequel le premier commutateur de sélection (S) sélectionne un signal d'entrée à connecter sur la base d'un signal de réglage (SEL) ; et
le premier commutateur de sélection sélectionne de se connecter au premier signal d'entrée lorsque le signal de réglage est un premier niveau ; ou le premier commutateur de sélection sélectionne de se connecter au second signal d'entrée lorsque le signal de réglage est un second niveau.

3. Amplificateur opérationnel selon la revendication 1, dans lequel le premier commutateur de sélection (S) sélectionne un signal d'entrée à connecter sur la base d'un signal de réglage ; et
le premier commutateur de sélection (S) du premier groupe de transistors de commutation (301-1) sélectionne de se connecter au premier signal d'entrée lorsque le signal de réglage (SEL) est un premier niveau ou sélectionne de se connecter à un second signal d'entrée lorsque le signal de réglage (SEL) est un second niveau ; et le premier commutateur de sélection (S) du second groupe de transistors de commutation (301-2) sélectionne de se connecter au premier signal d'entrée lorsque le signal de réglage (SEL) est un second niveau ou sélectionne de se connecter au second signal d'entrée lorsque le signal de réglage (SEL) est un premier niveau.

4. Amplificateur opérationnel selon l'une quelconque des revendications 1 à 3, dans lequel
le premier signal d'entrée est un signal de mode commun, et le second signal d'entrée est un signal de référence (Vref).

5. Amplificateur opérationnel selon la revendication 4, dans lequel l'amplificateur opérationnel comprend en outre un circuit diviseur de tension (303), une extrémité d'entrée du circuit diviseur de tension (303) est connectée à l'alimentation électrique (VDD) de l'amplificateur opérationnel, et une extrémité de sortie du circuit diviseur de tension (303) est configurée pour délivrer le signal de référence (Vref) ; et le circuit diviseur de tension (303) est configuré pour convertir une tension fournie par l'alimentation électrique (VDD) en signal de référence (Vref).

6. Circuit d'attaque de signal différentiel basse tension (101), dans lequel le circuit d'attaque de signal différentiel basse tension comprend l'amplificateur opérationnel selon l'une quelconque des revendications 1 à 5, et comprend en outre un circuit de génération de signal différentiel basse tension ;
une extrémité d'entrée du circuit de génération de signal différentiel basse tension est connectée à l'alimentation électrique (VDD), et une extrémité de signal de rétroaction du circuit de génération de signal différentiel basse tension est connectée à la première extrémité de sortie de l'amplificateur opérationnel ou à la seconde extrémité de sortie de l'amplificateur opérationnel ;
le circuit de génération de signal différentiel basse tension est configuré pour délivrer un signal de mode commun, et le signal de mode commun est un premier signal d'entrée de l'amplificateur opérationnel ; et
une extrémité de sortie du circuit de génération de signal différentiel basse tension est configurée pour délivrer un signal différentiel basse tension.

7. Circuit d'attaque de signal différentiel basse tension selon la revendication 6 comprenant l'amplificateur opérationnel selon la revendication 6, dans lequel un signal de référence (Vref) est un second signal d'entrée de l'amplificateur opérationnel.

8. Procédé de réglage de gain pour l'amplificateur opérationnel selon la revendication 2, dans lequel le procédé comprend :
la détermination (S1101) d'un gain cible ; et
la détermination (S1102) du signal de réglage (SEL) sur la base du gain cible, et
l'envoi du signal de réglage (SEL) aux premiers commutateurs de sélection (S).

9. Puce d'interface (1201, 1301, 1401, 1501), dans laquelle la puce d'interface comprend l'amplificateur opérationnel selon l'une quelconque des revendications 1 à 5, et la puce d'interface comprend un port d'alimentation (VDD), un premier port de sortie (OUT1), un second port de sortie (OUT2), un port de mise à la terre (GND), un port de commande (Vc), et un premier port d'entrée (INPUT) ;
l'amplificateur opérationnel est connecté à l'alimentation électrique (VDD) en utilisant le port d'alimentation (VDD), l'amplificateur opérationnel est mis à la terre en utilisant le port de mise à la terre (GND), une première extrémité de sortie de l'amplificateur opérationnel est connectée au premier port de sortie (OUT1), et une seconde extrémité de sortie de l'amplificateur opérationnel est connectée au second port de sortie (OUT2) ;
le premier port d'entrée (INPUT) est connecté à un signal de mode commun, et le signal de mode commun est un premier signal d'entrée de l'amplificateur opérationnel ; et
le premier groupe de transistors de commutation (301-1) et le second groupe de transistors de commutation (301-2) obtiennent un signal de réglage (SEL) par le port de commande (Vc).

10. Puce d'interface (1301, 1501) selon la revendication 9, dans laquelle la puce d'interface comprend en outre un port d'entrée de référence (VF) ; et
le port d'entrée de référence (VF) est configuré pour se connecter à un signal de référence (Vref), et le signal de référence (Vref) est un second signal d'entrée.

11. Dispositif électronique, dans lequel le dispositif électronique comprend la puce d'interface selon la revendication 9 ou 10.
